(19) **Europäisches Patentamt**
**European Patent Office**
**Office européen des brevets**

(11) **EP 3 439 066 B1**

(12) **EUROPEAN PATENT SPECIFICATION**

(45) Date of publication and mention
of the grant of the patent:
**27.04.2022 Bulletin 2022/17**

(21) Application number: **17775734.1**

(22) Date of filing: **23.03.2017**

(51) International Patent Classification (IPC):
**C23F 1/04** $^{(2006.01)}$     **C23F 1/02** $^{(2006.01)}$
**C23C 14/04** $^{(2006.01)}$     **H01L 51/00** $^{(2006.01)}$

(52) Cooperative Patent Classification (CPC):
**C23F 1/02; C23C 14/042; C23F 1/04;**
H01L 51/0011

(86) International application number:
**PCT/KR2017/003150**

(87) International publication number:
**WO 2017/171309 (05.10.2017 Gazette 2017/40)**

(54) **MASK FOR DEPOSITION FOR OLED PANEL**

MASKE ZUM BESCHICHTEN FÜR OLED TAFEL

MASQUE DE DÉPÔT POUR PANNEAU OLED

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.04.2016 KR 20160040051**

(43) Date of publication of application:
**06.02.2019 Bulletin 2019/06**

(60) Divisional application:
**22156871.0
22156872.8**

(73) Proprietor: **LG Innotek Co., Ltd.
Seoul 04637 (KR)**

(72) Inventors:
• **SON, Hyo Won**
  **Seoul 04637 (KR)**
• **PARK, Jae Seok**
  **Seoul 04637 (KR)**

(74) Representative: **Novagraaf Technologies
Bâtiment O2
2, rue Sarah Bernhardt
CS90017
92665 Asnières-sur-Seine Cedex (FR)**

(56) References cited:
**JP-A- 2014 133 932     JP-A- 2014 148 743
JP-A- 2014 218 749     KR-A- 20090 021 094
KR-A- 20140 070 255     KR-B1- 101 603 200
KR-B1- 101 603 200     US-A1- 2014 150 721**

# Description

[Technical Field]

The embodiment relates to a deposition mask. More particularly, an organic light emitting diode (OLED) panel can be fabricated using the deposition mask according to the embodiment.

[Background Art]

As a display device having higher resolution and representing lower power consumption is required, various display devices, such as liquid crystal display devices or electroluminescence display devices, have been developed.

As the electroluminescence display devices have more excellent characteristics including lower light emitting, lower power consumption, and higher resolution than those of the liquid crystal display devices, the electroluminescence display device have been spotlighted as next generation display devices.

The electroluminescence display devices include organic and inorganic electroluminescence display devices. In other words, the organic and inorganic electroluminescence display devices may be distinguished therebetween depending on materials of light emitting layers.

Among them, the organic electroluminescence display devices have attracted attention because the organic electroluminescence display devices have a wider viewing angle and a rapider response speed, and require lower power.

Organic materials of the light emitting layer may be included in patterns to form pixels on a substrate through a fine metal mask manner.

In this case, a fine metal mask, that is, a deposition mask may have through holes corresponding to patterns to be formed on the substrate. Therefore, as the organic materials are deposited after the fine metal mask is aligned on the substrate, red, green, and blue patterns may be formed to form pixels.

A metallic plate used as the deposition mask may be formed therein with through holes through an etching process.

In this case, if a significant difference is made between the thickness of the deposition mask measured in a non-etched area and the thickness of the deposition mask measured in an etched area to connect through holes with each other and to support the through holes, when the deposition mask is stretched, the deposition mask may be twisted in the etched area. In addition, a photoresist layer or a photosensitive film resist layer, which prevents etching in the etching process, may be delaminated. Accordingly, as etching uniformity may be degraded, the uniformity of the through holes may be degraded.

When the through holes are not uniform, deposition uniformity may be degraded. Accordingly, the deposition efficiency of the pattern is lowered, so that the process efficiency may be lowered.

The documents US 2014/150721 A1, JP 2014/148743 A and KR 101 603 200 B1 are relevant prior arts.

[Disclosure]

[Technical Problem]

The embodiment provides a deposition mask having uniform through holes.

[Technical Solution]

According to the embodiment, there is provided a deposition mask including a metallic plate as recited in claim 1. Further, advantageous embodiments are recited in the dependent claims.

In addition, according to the deposition mask of the embodiment, in the process of etching the metallic plate to form the through holes, the photoresist layer or the photosensitive film resist layer, which prevents etching, is prevented from being delaminated. Accordingly, as etching uniformity can be improved, the uniformity of the through holes can be improved.

Therefore, in the OLED panel fabricated using the deposition mask according to the embodiment, the deposition efficiency of the pattern can be excellently represented, and the deposition uniformity can be improved.

[Description of Drawings]

FIGS. 1 to 3 are schematic views to explain a process of depositing an organic material on a substrate.
FIGS. 4 and 5 are plan views showing a deposition mask.
FIG. 6 is a sectional view taken along line A-A' of FIG. 4.
FIG. 7 is a sectional view to explain a twisted index of the deposition mask
FIG. 8 is a plan view to explain the twisted index of the deposition mask
FIG. 9 is a sectional view taken along line A-A' of FIG. 4 according to the embodiment.
FIG. 10 is a sectional view taken along line A-A' according to a comparative example.
FIG. 11 is a sectional view to explain a deposition process using the deposition mask according to the embodiment.
FIG. 12 is a sectional view to explain a deposition process using the deposition mask according to the comparative example.

[Best Mode]

[Mode for Invention]

Hereinafter, the embodiment will be described with reference to accompanying drawing in detail.

In the following description referring to accompanying drawings, the same elements will be assigned with the same reference numerals, and the repetition in the description of the same elements will be omitted in order to avoid redundancy.

The terms "first" and "second" can be used to explain components, and the components are not limited to the term. The terms "first" and "second" are used only to distinguish one component from another component.

When a predetermined part "includes" a predetermined component, the predetermined part does not exclude other components, but may further include other components unless otherwise indicated.

The thicknesses and sizes of each layer (film), region, pattern, or structures shown in the drawings may be exaggerated, omitted or schematically drawn for the purpose of convenience or clarity. In addition, the sizes of elements do not utterly reflect actual sizes.

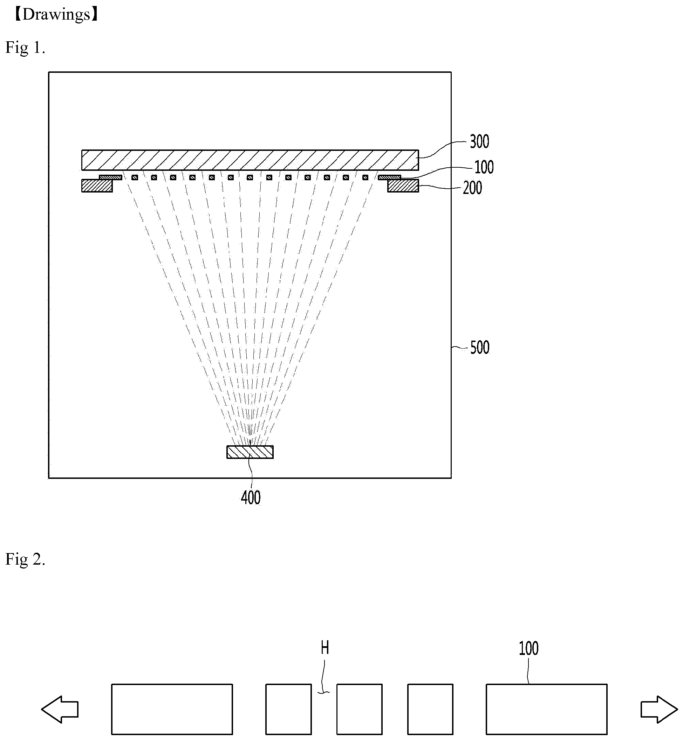

Hereinafter, a process of depositing an organic material on a substrate will be described with reference to FIGS. 1 to 3.

FIG. 1 is a view showing an organic material depositing device including a depositing mask 100 according to the embodiment.

The organic material depositing device may include the deposition mask 100, a mask frame 200, a substrate 300, an organic material deposition container 400, and a vacuum chamber 500.

The deposition mask 100 may include a plurality of through holes. The deposition mask 100 may be a metallic plate including a plurality of through holes. In this case, the through holes may be formed corresponding to a pattern to be formed on the substrate.

The mask frame 200 may include an opening. The through holes of the deposition mask 100 may be provided in an area corresponding to the opening. Accordingly, the organic material fed to the organic material deposition container 400 may be deposited on the substrate 300. The deposition mask may be provided and fixed onto the substrate 300. For example, the deposition mask may be stretched and fixed onto the mask frame 200 through a welding process.

Referring to FIGS. 1 and 2, the deposition mask 100 may be stretched from the outermost edge of the deposition mask 100 in opposite directions to each other. One end and an opposite end of the deposition mask 100 may be stretched in opposite directions to each other along the length of the deposition mask 100. One end and an opposite end of the deposition mask 100 may be provided in parallel to each other while facing face each other. One end of the deposition mask 100 may be one of end portions forming four edges provided at the outermost portions of the deposition mask 100. For example, the deposition mask 100 may be stretched by force of 0.4 kgf to 1.5 kgf. Accordingly, the deposition mask 100 may be mounted on the mask frame 200.

Next, the deposition mask 100 may be fixed onto the mask frame 200 by welding. Subsequently, a portion of the deposition mask 100, which is located at an outer portion of the mask frame 200, may be removed by cutting. For example, since the deposition mask 100 is deformed in the welding process, a portion of the deposition mask 100 may be removed when the deposition mask 100 may be provided in an area except for a fixing area in which the deposition mask 100 and the mask frame 200 are fixed to each other.

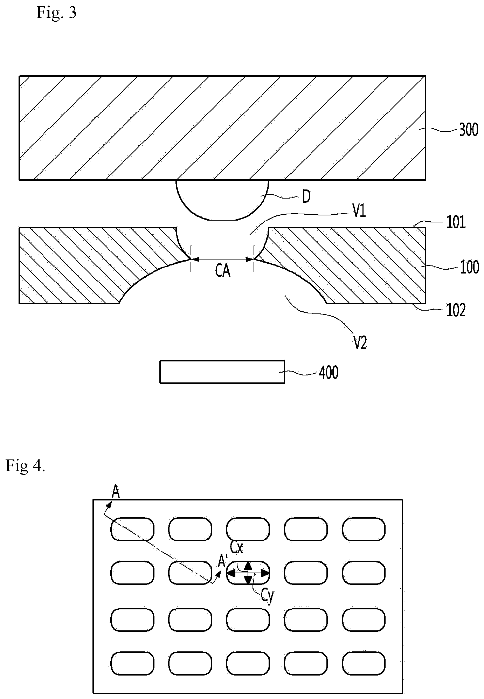

Referring to FIGS. 1 and 3, the substrate 300 may be a substrate used to fabricate a display device. In order to form pixels representing three primary colors of light, red, green, and blue patterns may be formed on the substrate 300.

The organic material deposition container 400 may be a crucible. An organic material may be provided in the crucible.

As heat and/or current is applied to the crucible in the vacuum chamber 500, the organic material may be deposited on the substrate 300.

FIG. 3 is an enlarged view showing one through hole of the deposition mask 100.

The deposition mask 100 may include a first surface 101 and a second surface 102 opposite to the first surface 101.

The first surface 101 of the deposition mask 100 may include a first surficial hole V1, and the second surface 102 of the deposition mask 100 may include a second surficial hole V2.

The through hole may be formed by a connection part CA through which the first and second surficial holes V1 and V2 communicate with each other.

The width of the surficial hole V2 may be wider than that of the first surficial hole V1. In this case, the width of the first surficial hole V1 may be measured on the first surface 101, and the width of the second surficial hole V2 may be measured on the second surface 102.

The first surficial hole V1 may be provided toward the substrate 300. Accordingly, the first surficial hole V1 may have a shape corresponding to a deposition material D, that is, a pattern.

The second surficial hole V2 may be provided toward the organic material deposition container 400. Accordingly, the second surficial hole V2 may widely receive the organic material fed from the organic material deposition container 400, and fine patterns may be rapidly formed on the substrate 300 through the first surficial hole V1 having a width narrower than that of the second surficial hole V2.

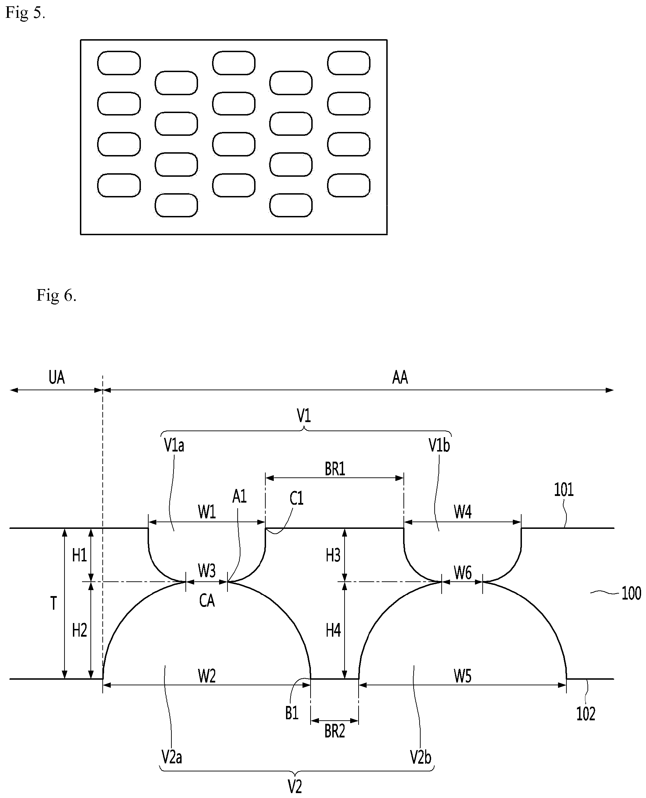

FIGS. 4 and 5 are front views of the deposition mask 100.

The deposition mask 100 may include a plurality of through holes. The through holes shown in FIG. 4 may represent the second surficial hole V2. When measuring a horizontal diameter Cx and a vertical diameter Cy of one through hole, that is, a reference hole, the difference between horizontal diameters Cx of adjacent holes (total six holes as shown in the drawing) and the difference between vertical diameters Cy of the holes may be realized in the range of 2% to 10%. In other words, when the difference in size between the adjacent holes to one reference hole is realized in the range of 2% to 10%, the deposition uniformity may be ensured.

For example, the difference in size between the reference hole and the adjacent holes may be in the range of 4% to 9%. For example, the difference in size between the reference hole and the adjacent holes may be in the range of 5% to 7%.

When the difference in size between the reference hole and the adjacent holes is less than 2%, Moire may be caused at a higher rate in an organic light emitting diode (OLED) panel after the deposition process. When the difference in size between the reference hole and the adjacent holes exceeds 10%, a color stain may be caused at a higher rate.

According to the embodiment, the difference in size between the reference hole and the adjacent holes may be realized to $\pm 3 \mu$m or less. Accordingly, the deposition efficiency may be improved.

The through holes may be aligned in line with each other or offset from each other according to directions.

For example, referring to FIG. 4, the through holes may be aligned in line with each other in longitudinal and transverse directions.

For example, referring to FIG. 5, the through holes may be arranged in line with each other in the longitudinal direction, and may be arranged in the transverse direction.

A first diameter of the through hole measured in the longitudinal direction may correspond to or be different from a second diameter of the through hole measured in the transverse direction. In addition, a third diameter of the through hole measured in a first diagonal direction corresponding to a direction of a section taken along line A-A' may correspond to or may be different from a fourth diameter measured in a second diagonal direction crossing the first diagonal direction. The through hole may be rounded.

FIG. 6 is an enlarged view showing sections of a plurality of through holes.

Referring to FIG. 6, the deposition mask 100 may include a metallic material. The deposition mask 100 may be provided in the form of a poly crystal, and may have a face-centered cube structure.

For example, the deposition mask 100 may include a nickel alloy. For example, the deposition mask 100 may include Invar containing about 35 to 37 % by weight of nickel (Ni), about 63 to 65 % by weight of iron (Fe), and a very small amount of at least one among C, Si, S, P, Cr, Mo, Mn, Ti, Co, Cu, Fe, Ag, Nb, V, In, and Sb. The very small amount mentioned above may refer to 1 % by weight or less. In detail, the very small amount mentioned above may refer to 0.5 % by weight or less. However, the embodiment is not limited thereto, but the deposition mask 100 may include various metallic materials.

The deposition mask 100 may include a plurality of first surficial holes V1 in the first surface 101. The first surficial hole V1 may include a first sub-first surficial hole V1a, and a second sub-first surficial hole V1b adjacent to the first sub-first surficial hole V1a.

The deposition mask 100 may include a plurality of second surficial holes V2 in the second surface 102. The second surficial hole V2 may include a first sub-second surficial hole V2a, and a second sub-second surficial hole V2b adjacent to the first sub-second surficial hole V2a.

The first sub-first surficial hole V1a communicates with the first sub-second surficial hole V2a through a connection part CA to define one through hole, and the second sub-first surficial hole V1b communicates with the second sub-second surficial hole V2b through a connection part CA to define another through hole. In other words, the deposition mask 100 may include a plurality of through holes.

The deposition mask 100 may have a thickness T of 10 $\mu$m to 50 $\mu$m. For example, the deposition mask 100 may have the thickness T of 10 $\mu$m to 30 $\mu$m. When the thickness T of the deposition mask 100 is less than 10 $\mu$m, the fabrication efficiency may be lowered.

When the thickness T of the deposition mask 100 exceeds 50 $\mu$m, the efficiency of a process of forming the through holes may be lowered. In this case, the thickness T of the deposition mask 100 may refer to a thickness measured after a rolling process.

The thickness T of the deposition mask 100 may be 50 $\mu$m or less. For example, the thickness of the deposition mask 100 may be 30 $\mu$m or less.

The deposition mask 100 may have through holes having widths which are mutually different from each other in a thickness direction of the through holes.

For example, a width W1 of the first sub-first surficial hole V1a may be wider than a width W3 of the connection part CA. In detail, the width of the through hole may be reduced along the first sub-first surficial hole V1a from the first surface 101 toward the connection part CA. In more detail, the width of the through hole may be gradually reduced along the first sub-first surficial hole V1a from the first surface 101 toward the connection part CA.

For example, a width W2 of the first sub-second surficial hole V2a may be wider than the width W3 of the connection part CA. In detail, the width of the through hole may be reduced along the first sub-second surficial hole V2a from the second surface 102 toward the connection part CA. In more detail, the width of the through hole may be gradually reduced along the first sub-second surficial hole V2a from the second surface 102 toward the connection part CA.

The thickness of the through hole may be 20 $\mu$m or more.

For example, at least one of the width W1 of the first sub-first surficial hole V1a and the width W2 of the first sub-second surficial hole V2a may be in the range of 20 $\mu$m to 50 $\mu$m. For example, at least one of the width W1 of the first sub-first surficial hole V1a and the width W2 of the first sub-second surficial hole V2a may be in the range of 30 $\mu$m to 50 $\mu$m. For example, at least one of the width W1 of the first sub-first surficial hole V1a and the width W2 of the first sub-second surficial hole V2a may be in the range of 20 $\mu$m to 40 $\mu$m.

In detail, the width W1 of the first sub-first surficial hole V1a may be in the range of 20 $\mu$m to 50 $\mu$m, and the width W2 of the first sub-second surficial hole V2a may be in the range of 50 $\mu$m to 90 $\mu$m. For example, the width W1 of the first sub-first surficial hole V1a may be in the range of 20 $\mu$m to 50 $\mu$m, and the width W2 of the first sub-second surficial hole V2a may be in the range of 60 $\mu$m to 90 $\mu$m. For example, the width W1 of the first sub-first surficial hole V1a may be in the range of 30 $\mu$m to 50 $\mu$m, and the width W2 of the first sub-second surficial hole V2a may be in the range of 70 $\mu$m to 90 $\mu$m.

A depth H2 of the first sub-second surficial hole V2a may be larger than a depth H1 of the first sub-first surficial hole V1a.

Meanwhile, the relation ratio of the depth H1 of the first sub-first surficial hole V1a to the thickness T of the deposition mask 100 may be 1: (3-30). For example, the relation ratio of the depth H1 of the first sub-first surficial hole V1a to the thickness T of the deposition mask 100 may be 1: (3.5-12.5). For example, the relation ratio of the depth H1 of the first sub-first surficial hole V1a to the thickness T of the deposition mask 100 may be 1: (4.5-10.5).

When the relation ratio of the depth H1 of the first sub-first surficial hole V1a to the thickness T of the deposition mask 100 exceeds the above range, the depth H1 of the first sub-first surficial hole V1a is increased, so that the change in the thickness of the organic material is increased. Accordingly, an area where the organic material is not deposited may be produced. Therefore, the fabrication yield rate of the OLED panel fabricated through the deposition mask may be degraded.

The depth H1 of the first sub-first surficial hole V1a may be in the range of 0.1 $\mu$m to 7 $\mu$m. For example, the depth H1 of the first sub-first surficial hole V1a may be in the range of 2 $\mu$m to 6.5 $\mu$m. For example, the depth H1 of the first sub-first surficial hole V1a may be in the range of 2 $\mu$m to 4.5 $\mu$m. When the depth H1 of the first sub-first surficial hole V1a is less than 0.1 $\mu$m, the deposition efficiency of the organic material through the deposition mask may be lowered. When the depth H1 of the first sub-first surficial hole V1a exceeds 7 $\mu$m, a fine pattern may not be formed, and an area where the organic material is not deposited may be produced. Therefore, the fabrication yield rate of the OLED panel fabricated through the deposition may be degraded.

The depth H2 of the first sub-second surficial hole V2a may be in the range of 15 $\mu$m to 25 $\mu$m. For example, the depth H2 of the first sub-second surficial hole V2a may be in the range of 20 $\mu$m to 25 $\mu$m.

An inclination angle of a line to link a predetermined point A1 at an end of the connection part CA with a predetermined point B1 at an end of the first sub-second surficial hole V2a may be in the range of 20° to 70°. For example, the inclination angle of the line to link the predetermined point A1 at the end of the connection part CA with the predetermined point B1 at the end of the first sub-second surficial hole V2a may be in the range of 30° to 60°. For example, the inclination angle of the line to link the predetermined point A1 at the end of the connection part CA with the predetermined point B1 at the end of the first sub-second surficial hole V2a may be in the range of 32° to 38° or the range of 52° to 58°. When the inclination angle of the line to link the predetermined point A1 at the end of the connection part CA with the predetermined point B1 at the end of the first sub-second surficial hole V2a is in the range of 20° to 70°, the deposition uniformity may be improved. When the inclination angle is out of the above range, an area where the organic material is not deposited may be produced. Accordingly, the deposition efficiency and the process efficiency may be lowered.

The width of the through hole may be reduced along the first surficial hole V1 toward the connection part in a depth direction of the deposition mask 100. For example, the inner surface of the first surficial hole V1 may have a structure with a curvature. In addition, the width of the through hole may be reduced along the second surficial hole V2 toward the connection part in the depth direction of the deposition mask 100. For example, the inner surface of the second surficial hole V2 may have a structure with a curvature. Accordingly, the introduction material of the deposition material may be adjusted, and the deposition uniformity may be improved as compared to a simple slope structure.

The difference W1-W3 between the width W1 of the first sub-first surficial hole V1a and the width W3 of the connection part CA may be in the range of 0.2 $\mu$m to 14 $\mu$m.

A vertical distance between a predetermined point C1 at the end of the first sub-first surficial hole V1a and a predetermined point A1 at the end of the connection part CA may be in the range of 0.1 $\mu$m to 7 $\mu$m. The vertical distance between the predetermined point C1 at the end of the first sub-first surficial hole V1a and the predetermined point A1 at the end of the connection part CA may be in the range of 1 $\mu$m to 6 $\mu$m. The vertical distance between the predetermined point C1 at the end of the first sub-first surficial hole V1a and the predetermined point A1 at the end of the connection part CA may be in the range of 2 $\mu$m to 4.5 $\mu$m.

When the vertical distance is less than 0.1 $\mu$m, the deposition efficiency of the organic material through the deposition mask 100 may be lowered. When the vertical distance exceeds 7 $\mu$m, the fine pattern may not be formed, and an area where the organic material is not deposited may be produced. Therefore, the fabrication yield rate of the OLED panel fabricated through the deposition may be degraded.

As the first surficial hole V1 is formed, an edge portion of an open area in the first surface 101, that is, an outer portion of the open area may have a curvature. In addition, as the second surficial hole V2 is formed, an edge portion of an open area in the second surface 102, that is, the outer portion of the open area may have a curvature. For example, the edge portion of the open area may have a rounding structure with a curvature in a predetermined range. The diameter of a virtual circle formed by increasing a curvature of the rounded portion of the edge part may be in the range of 5 $\mu$m to 20 $\mu$m. For example, the diameter of a virtual circle formed by increasing the curvature of the rounded portion of the edge part may be in the range of 7 $\mu$m to 15 $\mu$m. The diameter of a virtual circle formed by increasing the curvature of the rounded portion of the edge part may be in the range of 8 $\mu$m to 12 $\mu$m. In the above range, the higher deposition rate may be represented and the deposition material may be uniformly deposited.

When the diameter of the virtual circle formed by increasing the curvature of the rounded portion of the edge part may be less than 5$\mu$m, the deposition rate may not be greatly changed when comparing with the case that the curvature is not increased. When the diameter of the virtual circle formed by increasing the curvature of the rounded portion of the edge part may exceed 20 $\mu$m, the deposition rate may be lowered.

A width W5 of the second sub-second surficial hole V2b may be wider than a width W4 of the second sub-first surficial hole V1b. For example, the width W4 of the second sub-first surficial hole V1b may be wider than a width W6 of the connection part CA. In detail, the width of the through hole may be reduced along the second sub-first surficial hole V1b from the first surface 101 toward the connection part CA. In detail, the width of the through hole may be gradually reduced along the second sub-first surficial hole V1b from the first surface 101 toward the connection part CA.

For example, the width W5 of the second sub-second surficial hole V2b may be wider than the width W6 of the connection part CA. In detail, the width of the through hole may be reduced along the second sub-second surficial hole V2b from the second surface 102 toward the connection part CA. In more detail, the width of the through hole may be gradually reduced along the second sub-second surficial hole V2b from the second surface 102 toward the connection part CA.

A depth H4 of the second sub-second surficial hole V2b may be larger than a depth H3 of the second sub-first surficial hole V1b.

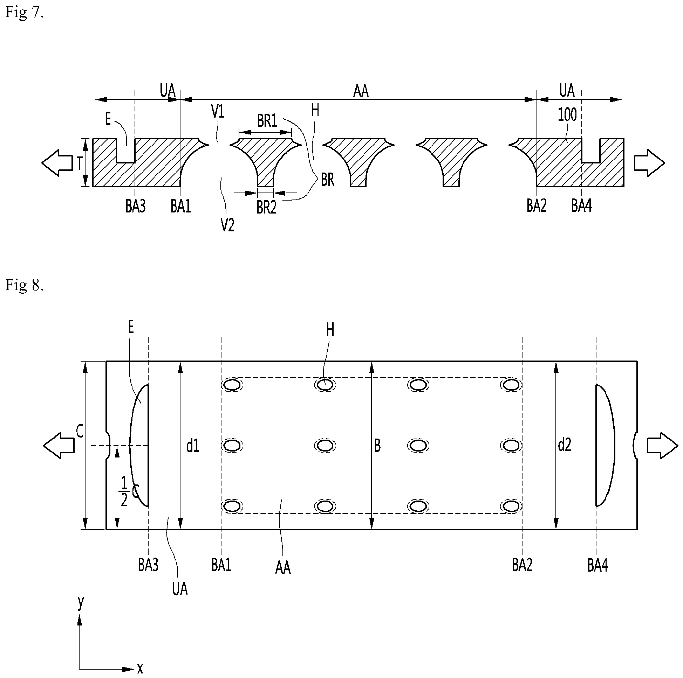

Referring to FIGS. 7 and 8, the deposition mask 100 may include an active area AA including a plurality of through holes H and a bridge BR interposed between the through holes, and an unactive area UA provided at an outer portion of the active area.

The active area AA may be an inner area when the outer portions of the outermost through holes are connected with each other. The unactive area UA may be an outer area when the outer portions of the outermost through holes are connected with each other. In detail, the end portion of the second surficial hole of the outermost hole may serve as the boundary between the active area AA and the unactive area UA.

The active area AA refers to an area at the inside of end points of the outermost second surficial hole V2, that is, an area allowing the introduction of the deposition material therein and provided therein with the second surficial hole V2. Meanwhile, an area located at the outside of end portions of the outermost second surficial hole V2, that is, an area, which is not involved in the deposition process, is defined as the unactive area UA.

The deposition mask 100 provided in the active area AA may support a plurality of through holes. In other words, a bridge may be provided between the through holes. In detail, the bridge may be provided between adjacent through holes. The though holes may be supported in uniform size by a first bridge part located on the first surface of the deposition mask 100 and a second bridge part located on the second surface of the metallic plate.

In addition, the deposition mask 100 provided in the active area AA may be an area (deposition area) involved in the deposition process to deposit an organic material, which is fed from the organic material deposition container, with a pattern width in a predetermined range on the substrate in the deposition process of the organic material.

The deposition mask 100 provided in the unactive area UA may be a non-etched area which does not include an open area. In other words, since the deposition mask 100 provided in the unactive area UA does not include the open area to pass through the organic material in the deposition process of the organic material, the deposition mask 100 may not be involved in the deposition process.

The unactive area UA may include a first half-etching part E and a second half-etching part E.

Referring to FIG. 7, the first and second half-etching parts E may include a groove formed in a first surface of the metallic plate. In other words, the first and second half-etching parts E may be formed therein with the groove as the first surface of the deposition mask 100, which is located in the unactive area UA, is partially etched. Accordingly, the deposition mask may have a step difference at an area where the first and second half-etching parts E are formed.

The deposition mask may have mutually different thickness in the unactive area UA. The thickness of a portion of the unactive area UA, which is not etched, may be greater than the thickness of a portion of the unactive area UA having the half-etching part E. For example, the first half-etching part and the second half-etching part may have a depth greater than a depth from the first surface to the through hole, and may be smaller than a depth of the second surficial hole. That is, the first half-etching part and the second half-etching part may be formed at a depth greater than the depth from the first surface to the connection part CA on the first surface. For example, the area where the half-etching part E is provided may have 1/2 of the thickness T measured in the portion of the unactive area UA which is not etched.

The half-etching part E and/or a peripheral area of the half-etching part E may be an area welded to the mask frame. For example, as the half-etching part E and/or the peripheral area of the half-etching part E is deformed through the welding process, the half-etching part E and/or the peripheral area of the half-etching part E may be fixed to the mask frame 200. In detail, the groove of the half-etching part E may be partially or entirely filled with a welding material.

Referring to FIG. 8, both end portions of the deposition mask 100 provided in the unactive area UA may be stretched in a horizontal direction, and fixed onto the mask frame. In more detail, one end and an opposite end of the deposition mask provided in the unactive area UA may be provided in parallel to a y axis direction, and may be stretched in an x axis direction perpendicular to the y axis direction, that is, horizontal direction.

The half-etching part E provided in the unactive area UA may partially or entirely have a rounded shape. For example, the half-etching part E provided in the unactive area UA may have a half-moon shape. In other words, the half-etching part E may have a linear shape or a curved shape. In detail, the half-etching part E may include a linear part extending in the vertical direction of the deposition mask and a curved part formed by linking both end portions of the linear part. In this case, the linear part may form an angle vertical to an end portion forming an x axis direction edge of the deposition mask. The linear part may have a length sufficient to cross the through holes. The linear part may be parallel to a vertically extending virtual line formed by linking the end portions of the second surficial holes located at the boundary between the active area and the unactive area. Meanwhile, the curved part may have a uniform curvature. In addition, the curved part may have mutually different curvatures depending on the locations. For example, on the assumption that the vertical length of the deposition mask is c, the curved part may have a curvature increased toward a point of 1/2 of the length. However, the embodiment is not limited thereto, but the half-etching part E may have a rectangular shape.

Referring to FIGS. 6, 7, and 9, in the case of the deposition mask according to the embodiment, the step difference of the deposition mask between the active area AA and the unactive area UA may be reduced.

A k value calculated through following Equation 1 may represent the ratio of the difference between the thickness of the deposition mask 100 in the unactive area UA, that is, the non-etched area, and the thickness of the deposition mask 100 in the active area AA, that is, the etched area.

$$\underline{\text{Equation 1}}$$
$$k = \frac{H2}{T - H1}$$

In Equation 1, T denotes the thickness T of the deposition mask 100 measured in the unactive area UA. In this case, T may be measured in the non-etched area. In other words, T is measured in an area where the half-etching part is not formed.

In Equation 1, H1 denotes a thickness defined in a direction of the first surface from the connection part at a point in which a bridge interposed between two adjacent through holes among the through holes has a maximum thickness, and H2 denotes a thickness defined in a direction of the second surface from the connection part at the point in which the bridge interposed between the two adjacent through holes has the maximum thickness.

In Equation 1, H1 and H2 are thicknesses measured from a bridge interposed between two through holes which are adjacent to each other in a diagonal direction among the through holes.

For example, H2 may refer to the shortest distance formed from the connection part CA to the second surface 102 provided therein with the second surficial hole V2 while being measured at the point in which a predetermined bridge has a maximum thickness. The shortest distance may be measured in the thickness direction of the substrate.

In the case of the deposition mask according to the embodiment, the k value calculated through Equation 1 may be in the range of 0.65 or more to less than 1.

In the case of the deposition mask according to the embodiment, the k value calculated through Equation 1 may be in the range of 0.8 or more to less than 1.0.

In other words, the thickness of the deposition mask measured in the non-etched area may make a slight difference from the thickness of the deposition mask to connect the through holes with each other and support the through holes, or the step difference may not be formed between the deposition mask in the non-etched area and the deposition mask in the etched area. Accordingly, when the deposition mask is stretched, the deposition mask may be prevented from being twisted in the etched area. In addition, the deposition mask according to the embodiment may prevent the photoresist layer or the photosensitive film resist layer, which prevents etching in the etching process, from being delaminated. Accordingly, as etching uniformity may be improved, the uniformity of the through holes may be improved. According to the embodiment, the difference in size between the reference hole and the adjacent holes may be realized with ±3 $\mu$m or less, so that the deposition efficiency may be improved.

When the k value calculated through Equation 1 is less than 0.65, a significant difference is made between the thickness of the deposition mask measured in the unactive area UA, that is, the non-etched area and the thickness of the deposition mask to connect the through holes with each other and to support the through holes in the active area AA, that is, the etched area. Accordingly, when the deposition mask is stretched, the deposition mask may be prevented from being twisted in the etched area.

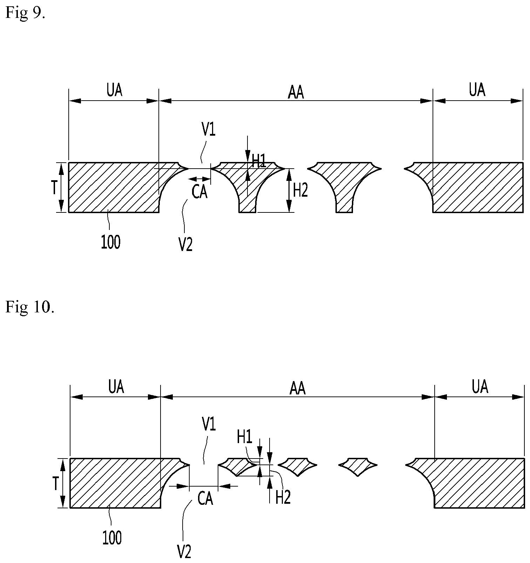

Hereinafter, problems occurring when H2 has a small value will be described with reference to FIG. 10. When the k value is decreased as the value of H2 is decreased, the photoresist layer or the photosensitive film resist layer, which prevents etching in the etching process, may be delaminated. In addition, as the etching uniformity is degraded, the uniformity of the through holes may be degraded. When the through holes are not uniform, the uniformity of the deposition may be degraded. Accordingly, the deposition efficiency of the pattern is lowered, so that the process efficiency may be lowered.

Hereinafter, a twisted index will be described with reference to FIGS. 7 and 8. When the deposition mask is stretched in the longitudinal direction, that is, the horizontal direction, the degree that the deposition mask is twisted may be expressed as $\alpha$ which is a twisted index in Equation 2.

### Equation 2

$$\alpha = \frac{2B}{d1 + d2}$$

The twisted index $\alpha$ is measured when the metallic plate is stretched by force of 0.7 kgf in the longitudinal direction.

In Equation 2, the d1 denotes a width of the metallic plate measured at an unactive area interposed between the first half-etching part and an active area adjacent to the first half-etching part, the d2 denotes a width of the metallic plate measured at an unactive area interposed between the second half-etching part and an active area adjacent to the second half-etching part, and the B denotes a width of the metallic plate measured at a middle point of the active area.

The active area and the unactive area may be divided into a first boundary area BA1 and a second boundary area BA2 in the vertical direction. A plurality of through holes and a bridge may be included between the first and second boundary areas BA1 and BA2.

A plurality of half-etching parts E may be included in the unactive area UA. For example, first and second half-etching parts E may be included in the unactive area UA. An active area adjacent to the first half-etching part may be the first boundary area BA1. An active area adjacent to the second half-etching part may be the second boundary area BA2. In detail, one half-etching part E, which is the first half-etching part, may be provided at an unactive area UA adjacent to the first boundary area BA1. Another half-etching part E, which is the second half-etching part, may be provided at an unactive area UA adjacent to the second boundary area BA2. In this case, curved parts of the half-etching parts E may have the shapes of protruding in the relevant horizontal stretching direction. Accordingly, the half-etching parts E may disperse stress applied when the deposition mask is stretched.

One lateral side of the half-etching part E adjacent to the first boundary area BA1 may be defined as a third boundary area BA3. One lateral side of the half-etching part E adjacent to the second boundary area BA2 may be defined as a fourth boundary area BA3.

In other words, the thickness of the metallic plate may be changed by the though holes from the first boundary area BA1 and the second boundary area BA2. In addition, the thickness of the metallic plate may be changed by the grooves from the third boundary area BA3 and the fourth boundary area BA4. In detail, the first, second, third, and fourth areas BA1, BA2, BA3, and BA4 may be areas representing boundaries of points where the thickness of the metallic plate is changed due to etching.

In Equation 2, the d1 denotes the width of the metallic plate measured at the unactive area interposed between the first half-etching part and the active area adjacent to the first half-etching part, and the d2 denotes the width of the metallic plate measured at the unactive area interposed between the second half-etching part and the active area adjacent to the second half-etching part.

In other words, the d1 and the d2 denote the vertical lengths of the deposition mask measured at 1/2 of the distance between the linear part of the half-etching part located in the unactive area UA and the second surficial holes located at the boundary between the active area and the unactive area.

In Equation 2, the B denotes the width of the metallic plate measured at the middle point of the active area. In other words, the B denotes the vertical length of the deposition mask measured at 1/2 of the distance between the measurement point of the d1 and the measurement point of the d2.

The deposition mask according to the embodiment may have the twisted index $\alpha$ in the range of 0.85 to 1.15 calculated through Equation 2. For example, the deposition mask according to the embodiment may have the twisted index $\alpha$ in the range of 0.9 to 1.1 calculated through Equation 2.

Since the deposition mask according to the embodiment may have a twisted index $\alpha$ in the range of 0.85 to 1.15, tensile force may be uniformly dispersed. In addition, the variation in the vertical length of the deposition mask according to the embodiment depending on locations may be reduced. Accordingly, since the variation in the width of the metallic plate of the deposition mask according to the embodiment in the active area AA and the unactive area UA may be reduced, the twisting of the through holes may be reduced.

When the twisted index $\alpha$ is less than 0.85 or exceeds 1.15, the twisting of the deposition mask provided in the active area AA to support the through holes may be increased. Accordingly, the deposition efficiency of the pattern formed by the deposition mask may be lowered. In addition, the patterns formed by the deposition mask may be overlapped with each other, so that the fabrication efficiency of the OLED panel may be lowered.

The deposition mask 100 provided in the active area AA may be formed integrally with the deposition mask 100 provided in the unactive area UA.

The deposition mask 100 provided in the active area AA may include bridges to support a plurality of through holes.

The bridge may include a first bridge part BR1 to support a part between the first surficial holes V1 provided in the first surface 101 of the metallic plate, and a second bridge part BR2 to support a part between the second surficial holes V2 provided in the second surface 102 of the metallic plate.

The first and second bridge parts BR1 and BR2 may have mutually different widths. A width of the first bridge part BR1 on the first surface may be wider than a width of the second bridge part BR2 on the second surface. In this case, the width of the first bridge part BR1 may be measured from the first surface, and the width of the second bridge part BR2 may be measured from the second surface. In detail, the width of the first bridge part BR1 may signify an average width of first bridge parts BR1 supporting a part between adjacent through holes. The width of the second bridge part BR2 may signify an average width of second bridge parts BR2 supporting a part between adjacent through holes.

The widths of the first and second bridge parts BR1 and BR2 may be varied depending on the thicknesses of the deposition mask. Accordingly, the following thicknesses are provided only for an illustrative purpose, and the embodiment is not limited thereto.

For example, the width of the first bridge part BR1 may be in the range of 20 $\mu$m to 50 $\mu$m. For example, the width of the first bridge part BR1 may be in the range of 30 $\mu$m to 45 $\mu$m. For example, the width of the first bridge part BR1 may be in the range of 30 $\mu$m to 40 $\mu$m.

For example, the width of the second bridge part BR2 may be in the range of 0.5 $\mu$m to 7 $\mu$m. For example, the width of the second bridge part BR2 may be in the range of 1 $\mu$m to 5 $\mu$m. For example, the width of the second bridge part BR2 may be in the range of 1 $\mu$m to 3 $\mu$m.

The first and second bridge parts BR1 and BR2 may have mutually different areas when viewed in a plan view. For example, the area of the first bridge part BR1 may be wider than the area of the second bridge part BR2 when viewed in a plan view.

The first bridge part BR1 may be flat. In addition, the second bridge part BR2 may be flat. Since the first bridge part BR1 and the second bridge part BR2 may be flat, the adhesive force of the photoresist layer or the photosensitive film resist layer, which prevents etching in the etching process, may be increased, the uniformity of the through holes may be improved.

A depth of the first surface of the deposition mask 100 measured in the active area AA corresponds to a depth of the first surface of the deposition mask 100 measured in the unactive area UA. A depth of the second surface of the deposition mask 100 measured in the active area AA corresponds to a depth of the second surface of the deposition mask 100 measured in the unactive area UA.

In addition, the difference between the depth of the first surface of the deposition mask 100 measured in the active area AA and the depth of the first surface of the deposition mask 100 measured in the unactive area UA may be smaller than the difference between the depth of the second surface of the deposition mask 100 measured in the active area AA and the depth of the second surface of the deposition mask 100 measured in the unactive area UA. Since the second surface of the deposition mask 100, which is a surface where the second surficial hole V2 is formed, has an etching area wider than that of the first surface, the depth difference between the second surfaces may be greater than the depth difference between the first surfaces.

In other words, the first surface 101 in the first bridge part BR1 may have the depth corresponding to that of the first surface 101 in the unactive area UA. Accordingly, the twisting caused by tension may be reduced.

In addition, the first surface 101 in the first bridge part BR1 may have the depth different from that of the first surface 101 in the unactive area UA. In this case, the first surface 101 in the first bridge part BR1 may be provided in parallel to the first surface 101 in the unactive area UA while facing the first surface 101 in the unactive area UA. Accordingly, the twisting caused by tension may be reduced.

For example, the depth of the first surface 101 in the first bridge part BR1 may have the difference of less than 5 $\mu$m from the depth of the first surface 101 in the unactive area UA. The depth difference includes 0 $\mu$m, and may be varied depending on the thicknesses of the deposition mask, but the embodiment is not limited thereto.

The second surface 102 in the second bridge part BR2 may have the depth corresponding to that of the second surface 102 in the unactive area UA. Accordingly, the twisting caused by the tension may be reduced.

In addition, the second surface 102 in the second bridge part BR2 may have the depth different from that of the second surface 102 in the unactive area UA. In this case, the second surface 102 in the second bridge part BR2 may be provided in parallel to the second surface 102 in the unactive area UA while facing the second surface 102 in the unactive area UA. Accordingly, the twisting caused by tension may be reduced.

For example, the depth of the second surface 102 in the second bridge part BR2 may have the difference of less than 5 $\mu$m from the depth of second surface 102 in the unactive area UA. The depth difference includes 0 $\mu$m, and may be varied depending on the thicknesses of the deposition mask, but the embodiment is not limited thereto.

In other words, since the deposition mask according to the embodiment may have a structure that is less twisted due to the tension, the through holes may be uniformly formed. Accordingly, the OLED panel fabricated using the deposition mask according to the embodiment may represent the excellent deposition efficiency of the patterns, and the uniformity of the deposition may be improved.

Hereinafter, the disclosure will be described in more detail through embodiments and comparative examples. The embodiments are provided only for the illustrative purpose of the disclosure, and the disclosure is not limited to the embodiments.

<Experimental example 1: Evaluation in uniformity of through hole according to k value>

Table 1

| k value | Uniformity of through holes |
|---------|------------------------------|
| 0.1 | Failure |
| 0.15 | Failure |
| 0.2 | Failure |
| 0.25 | Failure |
| 0.3 | Failure |
| 0.35 | Failure |
| 0.4 | Failure |
| 0.45 | Failure |
| 0.5 | Failure |
| 0.55 | Failure |
| 0.6 | Failure |
| 0.65 | Excellent |
| 0.7 | Excellent |
| 0.75 | Excellent |
| 0.8 | Excellent |
| 0.85 | Excellent |

(continued)

| k value | Uniformity of through holes |
|---------|------------------------------|
| 0.9 | Excellent |
| 0.95 | Excellent |
| 1.0 | Excellent |

Table 1 shows an evaluation result in the uniformity of the through holes according to the k value.

When the difference in size between the reference hole and the adjacent holes exceeds $\pm 3\mu$m, the uniformity of the through holes is marked as "Failure". When the difference in size between the reference hole and the adjacent holes is $\pm 3\mu$m or less, the uniformity of the through holes is marked as "Excellent".

Referring to table 1, when the k value is equal to or greater than 0.65, the uniformity of the through holes is improved. Accordingly, the deposition efficiency of the organic material pattern fabricated through the deposition mask according to the embodiment is improved.

When the k value is less than 0.65, as the uniformity of the through holes is degraded, the organic material pattern fabricated through the through holes is varied in size, so that the fabrication yield rate of the OLED panel may be degraded.

<Experimental example 2: Evaluation of twisting according to k value in stretching >

Table 2

| k value | Twisting in stretching |
|---------|------------------------|
| 0.1 | Failure |
| 0.15 | Failure |
| 0.2 | Failure |
| 0.25 | Failure |
| 0.3 | Failure |
| 0.35 | Failure |
| 0.4 | Failure |
| 0.45 | Failure |
| 0.5 | Failure |
| 0.55 | Failure |
| 0.6 | Failure |
| 0.65 | Failure |
| 0.7 | Failure |
| 0.75 | Failure |
| 0.8 | Excellent |

(continued)

| k value | Twisting in stretching |
|---------|------------------------|
| 0.85    | Excellent              |
| 0.9     | Excellent              |
| 0.95    | Excellent              |
| 1.0     | Excellent              |

Table 2 shows the evaluation result of the twisting of the deposition mask according the k value when stretching the deposition mask

In this case, the k value is obtained by measuring the twisting of the deposition mask when a sample of the deposition mask is stretched by force of 0.7 kgf.

When organic materials provided on the substrate are overlapped with each other or when the width differences among the R, G, and B patterns are irregularly made due to the twisting of the deposition mask, the table is marked as "Failure". When the organic materials provided on the substrate are not overlapped with each other, and when the width differences among the R, G, and B patterns are uniformly made, the table is marked as "Excellent".

Referring to table 2, when the k value is 0.8 or more, the twisting of the deposition mask in stretching may be lowered. Accordingly, the pattern layers formed on the substrate may be prevented from being overlapped with each other.

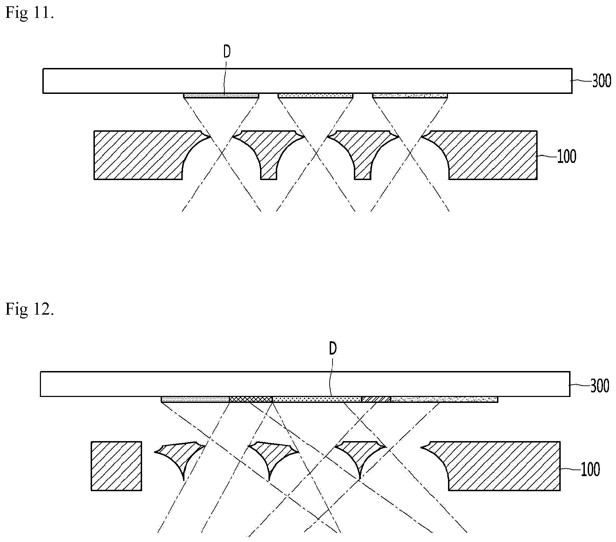

Referring to FIG. 11, in the case of the deposition mask according to the embodiment which represents the k value of 0.8 or more, the R, G, and B patterns are not overlapped with each other, and the width differences among the R, G, and B patterns are uniformly made. Accordingly, the fabrication yield rate of the OLED panel may be improved.

Meanwhile, when the k value is less than 0.8, the twisting of the deposition mask in stretching may be increased. Accordingly, the pattern layers formed on the substrate may be overlapped with each other.

Referring to FIG. 12, in the case of the deposition mask according to the comparative example which represents the k value of less than 0.8, the R, G, and B patterns may be overlapped with each other. Accordingly, the fabrication yield rate of the OLED panel may be improved.

In other words, when the k value is 0.8 or more in the deposition mask according to the embodiment, the uniformity of the through holes may be improved and the twisting of the deposition mask in stretching may be prevented. Accordingly, the deposition efficiency and the process efficiency of the OLED panel fabricated through the deposition mask may be improved.

**Claims**

1. A deposition mask (100) comprising a metallic plate,

   wherein the metallic plate includes: an active area (AA) having a plurality of through holes and a bridge interposed between the through holes; and an unactive area (UA) provided at an outer portion of the active area (AA), and
   wherein each through hole is formed in a connection part (CA) where a first surficial hole (V1) formed in a first surface (101) makes contact with a second surficial hole (V2) formed in a second surface (102) opposite to the first surface (101),
   a width of the first surficial hole (V1) is smaller than a width of the second surficial hole (V2),
   a depth of the first surficial hole (V1) is smaller than a depth of the second surficial hole (V2),
   wherein the unactive area (UA) includes a first half-etching part (E) positioned closer to one end in the longitudinal direction of the metallic plate and a second half-etching part (E) positioned closer to the other end opposite to the one end,
   wherein each of the first and second half-etching parts (E) includes a groove having a predefined depth,
   wherein the depth of the grooves of the first half-etching part (E) and the second half-etching part (E) is greater than a depth from the first surface (101) to the connecting part (CA) of the through hole, and smaller than a depth of the second surficial hole (V2),
   wherein the first half-etching part (E) and the second half-etching part (E) are formed on the first surface (101) of the metallic plate,
   wherein the first half-etching part (E) and the second half-etching part (E) are only formed on the unactive area (UA),
   wherein the first half-etching part (E) and the second half-etching part (E) include a linear part extending in the vertical direction of the metallic plate and a curved part formed by linking both end portions of the linear part,
   wherein, a first boundary area (BA1) being the active area adjacent to the first half-etching part and a second boundary area (BA2) being the active area adjacent to the second half-etching (E), the first half-etching part (E) is provided at the unactive area (UA) adjacent to the first boundary area (BA1) and the second half-etching part (E) is provided at the unactive area (UA) adjacent to the second boundary area (BA2),
   wherein the curved parts of the first half-etching part (E) and the second half-etching part (E) have the shapes of protruding in the relevant horizontal stretching direction, and
   wherein a k value calculated in Equation 1 is in a range of 0.65 or more to less than 1,

$$\text{Equation 1}$$
$$k = \frac{H2}{T - H1},$$

in which the T denotes a thickness of the deposition mask (100) measured in the unactive area (UA),

the H1 denotes a thickness defined in a direction of the first surface (101) from the connection part (CA) at a point in which a bridge interposed between two adjacent through holes among the through holes has a maximum thickness, and the H2 denotes a thickness defined in a direction of the second surface (102) from the connection part (CA) at the point in which the bridge interposed between the two adjacent through holes has the maximum thickness.

2. The deposition mask (100) of claim 1, wherein the k value calculated through Equation 1 is in a range of 0.8 or more to less than 1.

3. The deposition mask (100) of claim 1, wherein the thickness of the deposition mask (100) is in a range of 10 $\mu$m to 50 $\mu$m.

4. The deposition mask (100) of claim 1, wherein the thickness of the deposition mask (100) is in a range of 10 $\mu$m to 30 $\mu$m.

5. The deposition mask (100) of claim 1, wherein a relation ratio of the depth of the first surficial hole (V1) to the thickness of the deposition mask (100) is 1: (3-30).

6. The deposition mask (100) of claim 1, wherein a difference between the width of the first surficial hole (V1) and a width of the connection part (CA) is in the range of 0.2 $\mu$m to 14 $\mu$m.

7. The deposition mask (100) of claim 1, wherein a vertical distance between a predetermined point at the end of the first surficial hole (V1) and a predetermined point at the end of the connection part (CA) is in the range of 0.1 $\mu$m to 7 $\mu$m.

8. The deposition mask (100) of claim 1, wherein the first surficial hole (V1) has a curvature at an edge part of an open area in the first surface (101), and a diameter of a virtual circle formed by extending the curvature of a rounded portion of the edge part is in the range of 5 $\mu$m to 20 $\mu$m.

9. The deposition mask (100) of claim 1, wherein the deposition mask (100) includes an iron-nickel (Fe-Ni) alloy.

10. The deposition mask (100) of claim 1, wherein the H1 and H2 in Equation 1 are thicknesses measured in a bridge interposed between two through holes which are adjacent to each other in a diagonal direction among the through holes.

11. The deposition mask (100) of claim 1, wherein the width of the first surficial hole (V1) is in a range of 20 $\mu$m to 50 $\mu$m,

the width of the second surficial hole (V2) is in a range of 50 $\mu$m to 90 $\mu$m,
the depth of the first surficial hole (V1) is in a range of 0.1 $\mu$m to 7 $\mu$m, and
the depth of the second surficial hole (V2) is in a range of 20 $\mu$m to 25 $\mu$m.

**Patentansprüche**

1. Beschichtungsmaske (100) eine Metallplatte umfassend,

wobei die Metallplatte einschließt: einen aktiven Bereich (AA) mit einer Vielzahl von Durchgangslöchern und einer zwischen den Durchgangslöchern angeordneten Brücke; einen nicht aktiven Bereich (UA), der an einem äußeren Abschnitt des aktiven Bereiches (AA) vorgesehen ist, und wobei jedes Durchgangloch in einem Verbindungsteil (CA) ausgebildet ist, in dem ein erstes Oberflächenloch (V1), das in einer ersten Oberfläche (101) ausgebildet ist, mit einem zweiten Oberflächenloch (V2) in Kontakt steht, das in einer zweiten Oberfläche (102) gegenüber der ersten Oberfläche (101) ausgebildet ist, eine Breite des ersten Oberflächenloches (V1) kleiner als eine Breite des zweiten Oberflächenloches (V2) ist, eine Tiefe des ersten Oberflächenloches (V1) kleiner als eine Tiefe des zweiten Oberflächenloches (V2) ist, wobei der nicht aktive Bereich (UA) einen ersten Halbätzteil (E), der sich in der Nähe eines Endes in Längsrichtung der Metallplatte befindet und einen zweiten Halbätzteil (E), der in der Nähe des anderen Endes gegenüber des einen Endes positioniert ist, einschließt, wobei jeder des ersten und zweiten Halbätzteils (E) eine Nut mit einer vorgegebenen Tiefe einschließt, wobei die Tiefe der Nuten des ersten Halbätzteils (E) und des zweiten Halbätzteils (E) größer als eine Tiefe der ersten Oberfläche (101) zum Verbindungsteil (CA) des Durchgangsloches und kleiner als eine Tiefe des zweiten Oberflächenloches (V2) ist,

wobei der erste Halbätzteil (E) und der zweite Halbätzteil (E) auf der ersten Oberfläche (101) der Metallplatte ausgebildet sind,

wobei der erste Halbätzteil (E) und der zweite Halbätzteil (E) nur auf dem nicht aktiven Bereich (UA) ausgebildet sind,

wobei der erste Halbätzteil (E) und der zweite Halbätzteil (E) einen linearen Teil beinhalten, der sich in vertikaler Richtung der Metallplatte erstreckt und einen gekrümmten Teil, der durch Verbinden beider Endabschnitte des linearen Teils gebildet wird,

wobei, wenn ein erster Grenzbereich (BA1) der aktive Bereich ist, der am ersten Halbätzteil angrenzt, und ein zweiter Grenzbereich (BA2) der aktive Bereich ist, der am zweiten Halbätzteil (E) angrenzt, der erste Halbätzteil (E) an dem nicht aktiven Bereich (UA) zur Verfügung steht, der an den ersten Grenzbereich (BA1) angrenzt, und der zweite Halbätzteil (E) an dem nicht aktiven Bereich (UA) zur Verfügung steht, der an den zweiten Grenzbereich (BA2) angrenzt.

wobei die gekrümmten Teile des ersten Halbätzteils (E) und des zweiten Halbätzteils (E) eine Form haben, die in die relevante horizontale Streckrichtung hineinragt, und

wobei ein in Gleichung 1 berechneter k-Wert in einer Größenordnung von 0,65 oder mehr bis weniger als 1 liegt,

$$\underline{Gleichung\ 1}$$

$$k = \frac{H2}{T - H1},$$

in der T eine Dicke der Beschichtungsmaske (100), gemessen in der nicht aktiven Zone (UA), bezeichnet

H1 eine Dicke bezeichnet, die in einer Richtung der ersten Oberfläche (101) von dem Verbindungsteil (CA) an einem Punkt definiert ist, an dem eine zwischen zwei benachbarten Durchgangslöchern eingefügte Brücke inmitten der Durchgangslöcher eine maximale Dicke aufweist, und

H2 eine Dicke bezeichnet, die in einer Richtung der zweiten Oberfläche (102) von dem Verbindungsteil (CA) an dem Punkt definiert ist, an dem die zwischen den beiden benachbarten Durchgangslöchern eingefügte Brücke die maximale Dicke aufweist.

2.  Beschichtungsmaske (100) gemäß Anspruch 1, wobei der durch Gleichung 1 berechnete k-Wert in einem Bereich von 0,8 oder mehr bis weniger als 1 liegt.

3.  Beschichtungsmaske (100) gemäß Anspruch 1, wobei die Dicke der Beschichtungsmaske (100) in einer Größenodnung von 10 μm bis 50 μm liegt.

4.  Beschichtungsmaske (100) gemäß Anspruch 1, wobei die Dicke der Beschichtungsmaske (100) in einer Größenodnung von 10 μm bis 30 μm liegt.

5.  Beschichtungsmaske (100) gemäß Anspruch 1, wobei ein Verhältnis zwischen der Tiefe des ersten Oberflächenlochs (V1) und der Dicke der Beschichtungsmaske (100) 1:(3-30) ist.

6.  Beschichtungsmaske (100) gemäß Anspruch 1, wobei eine Differenz zwischen der Breite des ersten Oberflächenloches (V1) und einer Breite des Verbindungsteiles (CA) in der Größenodnung von 0,2 μm bis 14 μm liegt.

7.  Beschichtungsmaske (100) gemäß Anspruch 1, wobei ein vertikaler Abstand zwischen einem vorgegebenen Punkt am Ende des ersten Oberflächenloches (V1) und einem vorgegebenen Punkt am Ende des Verbindungsteils (CA) im Bereich von 0,1 μm bis 7 μm liegt.

8.  Beschichtungsmaske (100) gemäß Anspruch 1, wobei das erste Oberflächenloch (V1) eine Krümmung an einem Randteil eines offenen Bereichs in der ersten Oberfläche (101) aufweist, und ein Durchmesser eines virtuellen Kreises, der durch Verlängerung der Krümmung eines abgerundeten Abschnitts des Randteils gebildet wird, im Bereich von 5 μm bis 20 μm liegt.

9.  Beschichtungsmaske (100) gemäß Anspruch 1, wobei die Beschichtungsmaske (100) eine Eisen-Nickel-Legierung (Fe-Ni) einschließt.

10. Beschichtungsmaske (100) gemäß Anspruch 1, wobei H1 und H2 in Gleichung 1 Dicken sind, die in einer Brücke gemessen werden, die zwischen zwei Durchgangslöchern eingefügt ist, die in einer diagonalen Richtung inmitten der Durchgangslöcher benachbart sind.

11. Beschichtungsmaske (100) gemäß Anspruch 1, wobei die Breite des ersten Oberflächenloches (V1) in einer Größenordnung von 20 μm bis 50 μm liegt,

    die Breite des zweiten Oberflächenloches (V2) in einer Größenordnung von 50 μm bis 90 μm liegt,
    die Breite des ersten Oberflächenloches (V1) in

einer Größenordnung von 0,1 μm bis 7 μm liegt, und

die Breite des zweiten Oberflächenloches (V2) in einer Größenordnung von 20 μm bis 25 μm liegt.

## Revendications

1. Masque de dépôt (100) comprenant une plaque métallique,

dans lequel la plaque métallique comporte : une aire active (AA) ayant une pluralité de trous traversants et un pont interposé entre les trous traversants ; et une aire inactive (UA) ménagée au niveau d'une portion externe de l'aire active (AA), et

dans lequel chaque trou traversant est formé dans une partie de liaison (CA) où un premier trou superficiel (V1) formé dans une première surface (101) est en contact avec un second trou superficiel (V2) formé dans une seconde surface (102) opposée à la première surface (101), une largeur du premier trou superficiel (V1) est plus petite qu'une largeur du second trou superficiel (V2),

une profondeur du premier trou superficiel (V1) est plus petite qu'une profondeur du second trou superficiel (V2),

dans lequel l'aire inactive (UA) comporte une première partie de demi-gravure (E) positionnée plus près d'une extrémité dans la direction longitudinale de la plaque métallique et une seconde partie de demi-gravure (E) positionnée plus près de l'autre extrémité opposée à l'une extrémité,

dans lequel chacune des première et seconde parties de demi-gravure (E) comporte une rainure ayant une profondeur prédéfinie,

dans lequel la profondeur des rainures de la première partie de demi-gravure (E) et de la seconde partie de demi-gravure (E) est plus grande qu'une profondeur de la première surface (101) à la partie de liaison (CA) du trou traversant, et plus petite qu'une profondeur du second trou superficiel (V2),

dans lequel la première partie de demi-gravure (E) et la seconde partie de demi-gravure (E) sont formées sur la première surface (101) de la plaque métallique,

dans lequel la première partie de demi-gravure (E) et la seconde partie de demi-gravure (E) sont uniquement formées sur l'aire inactive (UA),

dans lequel la première partie de demi-gravure (E) et la seconde partie de demi-gravure (E) comportent une partie linéaire s'étendant dans la direction verticale de la plaque métallique et une partie incurvée formée par la jonction des deux portions d'extrémité de la partie linéaire, dans lequel, une première aire limite (BA1) étant l'aire active adjacente à la première partie de demi-gravure et une seconde aire limite (BA2) étant l'aire active adjacente à la seconde partie de demi-gravure (E), la première partie de demi-gravure (E) est ménagée au niveau de l'aire inactive (UA) adjacente à la première aire limite (BA1) et la seconde partie de demi-gravure (E) est ménagée au niveau de l'aire inactive (UA) adjacente à la seconde aire limite (BA2),

dans lequel les parties incurvées de la première partie de demi-gravure (E) et de la seconde partie de demi-gravure (E) possèdent des formes faisant saillie dans la direction d'étirement horizontale concernée, et

dans lequel une valeur k calculée à l'Équation 1 est dans une plage de 0,65 ou plus à moins de 1,

$$\text{Équation 1}$$
$$k = \frac{H2}{T - H1}$$

dans laquelle le T représente une épaisseur du masque de dépôt (100) mesurée dans l'aire inactive (UA),

le H1 représente une épaisseur définie dans une direction de la première surface (101) à partir de la partie de liaison (CA) au niveau d'un point dans lequel un pont interposé entre deux trous traversants adjacents parmi les trous traversants possède une épaisseur maximale, et

le H2 représente une épaisseur définie dans une direction de la seconde surface (102) à partir de la partie de liaison (CA) au niveau du point dans lequel le pont interposé entre les deux trous traversants adjacents possède l'épaisseur maximale.

2. Masque de dépôt (100) selon la revendication 1, dans lequel la valeur k calculée par le biais de l'Équation 1 est dans une plage de 0,8 ou plus à moins de 1.

3. Masque de dépôt (100) selon la revendication 1, dans lequel l'épaisseur du masque de dépôt (100) est dans une plage de 10 μm à 50 μm.

4. Masque de dépôt (100) selon la revendication 1, dans lequel l'épaisseur du masque de dépôt (100) est dans une plage de 10 μm à 30 μm.

5. Masque de dépôt (100) selon la revendication 1, dans lequel un rapport de relation de la profondeur du premier trou superficiel (V1) sur l'épaisseur du masque de dépôt (100) est de 1:(3 à 30).

6. Masque de dépôt (100) selon la revendication 1, dans lequel une différence entre la largeur du premier trou superficiel (V1) et une largeur de la partie de liaison (CA) est dans la plage de 0,2 μm à 14 μm.

7. Masque de dépôt (100) selon la revendication 1, dans lequel une distance verticale entre un point prédéterminé au niveau de l'extrémité du premier trou superficiel (V1) et un point prédéterminé au niveau de l'extrémité de la partie de liaison (CA) est dans la plage de 0,1 μm à 7 μm.

8. Masque de dépôt (100) selon la revendication 1, dans lequel le premier trou superficiel (V1) possède une courbure au niveau d'une partie de bord d'une aire ouverte dans la première surface (101), et un diamètre d'un cercle virtuel formé par l'extension de la courbure d'une portion arrondie de la partie de bord est dans la plage de 5 μm à 20 μm.

9. Masque de dépôt (100) selon la revendication 1, dans lequel le masque de dépôt (100) comporte un alliage fer-nickel (Fe-Ni).

10. Masque de dépôt (100) selon la revendication 1, dans lequel les H1 et H2 dans l'Équation 1 sont des épaisseurs mesurées dans un pont interposé entre deux trous traversants qui sont adjacents l'un à l'autre dans une direction diagonale parmi les trous traversants.

11. Masque de dépôt (100) selon la revendication 1, dans lequel la largeur du premier trou superficiel (V1) est dans une plage de 20 μm à 50 μm,

la largeur du second trou superficiel (V2) est dans une plage de 50 μm à 90 μm,
la profondeur du premier trou superficiel (V1) est dans une plage de 0,1 μm à 7 μm, et
la profondeur du second trou superficiel (V2) est dans une plage de 20 μm à 25 μm.

【Drawings】

Fig 1.

Fig 2.

Fig. 3

Fig 4.

Fig 5.

Fig 6.

Fig 7.

Fig 8.

Fig 9.

Fig 10.

Fig 11.

Fig 12.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014150721 A1
- JP 2014148743 A

- KR 101603200 B1